# EUROPEAN PATENT APPLICATION

(11) **EP 4 628 961 A1**
(43) Date of publication of application: **08.10.2025**
(21) Application number: 24168826.6
(22) Date of filing: 05.04.2024
(51) Int. Cl.: G02B 7/18, G03F 7/00

(54) **BEAM GUIDING DEVICE FOR GUIDING LASER RADIATION AND LITHOGRAPHY SYSTEM**

(71) Applicant: TRUMPF Lasersystems for Semiconductor Manufacturing SE, 71254 Ditzingen (DE); ASML Netherlands B.V., 5504 DR Veldhoven (NL)
(72) Inventor: JANSSEN, Toni Wil, 6005 NX Weert (NL); STRUYCKEN, Alexander Matthijs, 5629 Eindhoven (NL); GORECKI, Dominik Eryk, 5500 AH Veldhoven (NL); MORHAI, Patrick, 71665 Vaihingen an der Enz (DE)
(74) Representative: Kutzenberger Wolff & Partner

(57) **Abstract**

The present invention concerns a beam guiding device (200) for guiding laser radiation, comprising a body (201) with an inner beam channel (202) and an optical beam guiding element (205), in particular a mirror, that is arranged inside the beam channel (202), wherein at least one sleeve (210, 211) is arranged inside the beam channel (202) such that a gap (207) exists between an outer surface of the sleeve (210, 211) and an inner surface of the body (201) for thermally decoupling the sleeve (210, 211) from the body (201). The present invention further concerns a lithography system (101), in particular extreme ultraviolet lithography system, comprising a drive laser (100) with a beam guiding device (200) as mentioned before.

## Description

The invention concerns a beam guiding device for guiding laser radiation, comprising a body with an inner beam channel and an optical beam guiding element, in particular a mirror, that is arranged inside the beam channel. The invention further concerns a lithography system, in particular an extreme ultraviolet lithography system.

The invention can be applied in the field of drive laser systems for use in extreme ultraviolet (EUV) lithography. Those drive laser systems typically include a laser source for generating pulsed laser radiation and one or more optical amplifiers for amplifying the pulsed laser radiation. Generally, the optical amplifiers include cavities that are filled with a laser gas, e.g., a mixture comprising CO₂, N₂ and He. The laser gas may be excited by radio-frequency (RF) signals applied to the laser gas using electrodes.

Optical beam guiding elements like mirrors are employed to guide the laser radiation from one cavity to the other or from the drive laser to a focussing device. The optical beam guiding elements are typically attached to a body of a beam guiding device. Stray light may be generated by optical windows, pinhole apertures or mirrors. This stray light is absorbed by the body of the beam guiding device and typically causes inhomogeneous heating of the body. Such inhomogeneous heating may lead to thermo-mechanical deformations of the body and, thus, may change the position of the optical beam guiding element attached to the body. In prior art optical beam guiding elements of drive lasers for EUV lithography such deformations can have a significant impact on the total laser beam drift.

Against this background, the problem underlying the invention is to suppress the stray light induced laser beam drift in drive lasers for EUV lithography.

According to an aspect of the **invention**, a beam guiding device for guiding laser radiation is provided, comprising a body with an inner beam channel and an optical beam guiding element, in particular a mirror, that is arranged inside the beam channel, wherein at least one sleeve is arranged inside the beam channel such that a gap exists between an outer surface of the sleeve and an inner surface of the body for thermally decoupling the sleeve from the body.

In the inventive beam guiding device, a sleeve is provided inside the beam channel which is exposed to stray light generated by the laser radiation. Thus, the body of the beam guiding device is shielded by the sleeve from the stray light. The stray light may be absorbed by the sleeve which consequently heats up. Due to the gap provided between the sleeve and the body of the beam guiding device heat transfer from the sleeve to the body is drastically reduced. As a result, heating of the body and thermo-mechanical deformations of the body can be minimized. This increases stability of the position of the optical beam guiding element of the beam guiding device and suppresses drift of the beam of laser radiation through the beam guiding device.

The optical beam guiding element, in particular the mirror, may be directly or indirectly attached to the body of the beam guiding device. Due to the provision of the sleeve being thermally decoupled from the body, stray light induced deformations of the body and displacements of optical beam guiding elements attached to that body can be reduced.

The body may comprise, in particular consist of, a metal, e.g., aluminium. The sleeve may comprise, in particular consist of, a metal, e.g., from steel, in particular stainless steel or aluminium, whereas aluminium is preferred due to a comparably high thermal conductivity.

According to a preferred embodiment of the invention, the gap is filled with a gas, in particular with air. With respect to the thermally decoupling of the sleeve and the body a gas like air has been proven to sufficiently decrease heat transfer. The use of a gas, however, comes with the additional benefit or mechanically decoupling the sleeve from the body so that the transfer of mechanical deformations from the sleeve towards the body is reduced. Alternatively, the gap may be filled with a solid-state material having a low thermal conductivity, e.g., a thermal conductivity of below 1 W/(m*K), preferably a thermal conductivity of below 0.5 W/(m*K), most preferably a thermal conductivity of below 0.1 W/(m*K).

According to a preferred embodiment of the invention, the gap has a value between 1 mm and 5 mm, in particular between 2 mm and 4 mm, for example essentially 3 mm. A gap in this range has been proven to sufficiently thermally decouple the sleeve from the body.

According to a preferred embodiment of the invention, the beam channel has a tubular channel segment and the sleeve has a tubular sleeve segment which is arranged within the tubular channel segment, in particular concentrically within the tubular channel segment, such that the gap exists between the outer surface of the tubular sleeve segment and the inner surface of the tubular channel segment. The tubular channel and sleeve segments allow to provide an encapsulated beam path in the body of the beam guiding device. The tubular channel segment and/or the tubular the tubular sleeve segment may be hollow cylindrical.

According to a preferred embodiment of the invention, the sleeve comprises a flange region which is attached to the body via a thermally insulating connection. The flange region may extend perpendicular to a longitudinal axis of the sleeve, in particular perpendicular to a longitudinal axis of a tubular sleeve segment of the sleeve. The flange region is preferably attached to the body nearby or at an entry opening of the beam channel. Alternatively, the flange region is attached to the body nearby or at an exit opening of the beam channel. The thermal conductivity of the thermally insulating connection is preferably below 0,5 W/(m*K), most preferably below 0.1 W/(m*K). The connection may include one or more screws. The screws may be screwed into the body. In the flange region, the sleeve may comprise a hole for introducing a screw. The hole may be a round hole or an elongated hole. It is possible to use three screws. By way of this, it is possible to reduce the possibility of an overdeterminacy in certain specific constructive implementations. An effect of using three screws could also be to reduce the tension inside the sleeve for example during heating cycles. The screws may each be additionally supported by a spring below a screw head of the screws in order to create comparably more stable connections.

According to a preferred embodiment of the invention, the thermally insulating connection comprises a thermally insulating washer. The washer may improve the thermal decoupling of the sleeve and the body. The washer preferably consists of a material having a Young's modulus below 4 GPa. Thereby, also the mechanical decoupling of the sleeve and the body can be improved. The washer may, e.g., made from polytetrafluoroethylene (PTFE) or polyether ether ketone (PEEK).

According to a preferred embodiment of the invention, wherein the sleeve comprises a cooling fluid channel for cooling the sleeve. By way of the cooling fluid channel heat may be removed from the sleeve thereby further shielding the body from heat induced by the absorption of stray light in the sleeve. The cooling fluid channel may be filled with and/or traversed by water as a cooling fluid. Alternatively, oil may be used as cooling fluid. The cooling fluid channel is preferably an internal channel of the sleeve such that the core material of the sleeve surrounds the channel in a direction perpendicular to the longitudinal direction of the channel.

According to a preferred embodiment of the invention, the cooling fluid channel is arranged in the flange region. As the flange region is attached to the body, cooling the flange region can significantly reduce the heat transfer from the sleeve to the body via the connection of the flange region with the body. Preferably, the flange region comprises through holes for screws or similar attachment elements and the cooling fluid channel is arranged in between the inner surface of the sleeve and the through holes so as to remove heat introduced in the sleeve due to absorption of stray light at the inner surface of the sleeve.

According to a preferred embodiment of the invention, the cooling fluid channel is, alternatively or additionally, arranged in in the tubular sleeve segment. Thereby, the sleeve can be cooled in the tubular sleeve segment. The cooling channel can have a helical shape or meandering shape.

According to a preferred embodiment of the invention, the sleeve comprises a pinhole aperture. The pinhole aperture may serve as a dedicated diffraction structure to diffract laser light that is slightly of the main optical axis. The sleeve preferably comprises a dedicated absorption region arranged such that laser light diffracted by the pinhole aperture can be absorbed at the absorption region. The absorption region may be located at the inner surface of the sleeve. The absorption region preferably comprises an absorption structure, e.g., a structure increasing the surface area of the absorption region compared to other regions of the sleeve. Such structure may comprise a sequence of valleys and peaks on the inner surface of the sleeve.

According to a preferred embodiment of the invention, at least two sleeves are arranged inside the beam channel such that a gap exists between an outer surface of the sleeves and an inner surface of the body for thermally decoupling the sleeves from the body. By using two or more sleeves in the beam channel, an angled beam channel may easily be provided with sleeves over the beam channel form an entry opening to an exit opening.

According to a preferred embodiment of the invention, a first sleeve of the at least two sleeves extends into the beam channel from an entry opening of the body and a second sleeve of the at least two sleeves extends into the beam channel from an exit opening of the body. Such embodiment improves manufacturing of the beam guiding device as the two sleeves may be introduced into the beam channel from different sides of the body. Preferably, the two sleeves are arranged such that their longitudinal axis include an angle less than 180°, for example essentially 90°.

According to a preferred embodiment of the invention, the at least two sleeves each comprise an opening that connects to at least one other sleeve and the optical beam guiding element, e.g., a mirror. Via the opening a connection may be formed between the two sleeves. In the connection region the optical beam guiding element may guide, in particular reflect, the laser radiation introduced via one of the sleeves towards the other sleeve.

According to another aspect of the invention, a lithography system, in particular an extreme ultraviolet lithography system, is provided, comprising a drive laser with a beam guiding device as disclosed before.

The lithography system may provide the same technical benefits and advantages as the inventive beam guiding device. Thus, reference is made to the respective description relating to the inventive beam guiding device.

According to a preferred embodiment of the invention, the beam guiding device is arranged nearby a window, in particular a diamond window, or nearby an aperture, that is configured for being arranged in the beam of laser radiation. This embodiment has the advantage that heat generation in the body of the beam guiding device can be minimized in areas of high stray light exposure such as nearby an aperture or a diamond window.

Alternatively, or additionally, the advantageous embodiments and features disclosed in combination with the inventive optical amplifier can, alone or in combination, be applied to the inventive method.

Further details and advantages of the invention will be elucidated in the following using the embodiment shown in the figure.
- Fig. 1: depicts a block diagram of an embodiment of an extreme ultraviolet lithography system according to the invention;
- Fig. 2: depicts a beam guiding device according to an embodiment of the invention configured for use in the lithography system according to Fig. 1 in a perspective view;
- Fig. 3: depicts the beam guiding device of Fig. 2 in a sectional view;
- Fig. 4: depicts a sleeve of a beam guiding device according to another embodiment of the invention in a perspective view;
- Fig. 5: depicts a sleeve of a beam guiding device according to yet another embodiment of the invention in a sectional view;
- Fig. 6: depicts a sleeve of a beam guiding device according to yet another embodiment of the invention in a perspective view;
- Fig. 7: depicts a sleeve of a beam guiding device according to yet another embodiment of the invention in a sectional view;
- Fig. 8: depicts a sleeve of a beam guiding device according to yet another embodiment of the invention in a sectional view.

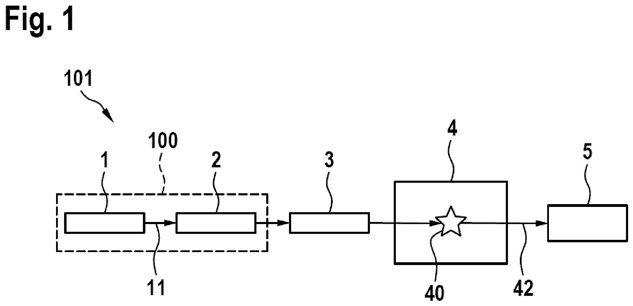

The embodiment in **Fig. 1** shows an extreme ultraviolet, EUV, lithography system 101 with a drive laser 100 that provides laser radiation to a focussing device 3, which focusses the laser radiation 11 onto a target area 40. A target material is arranged in the target area, which emits EUV radiation when irradiated with the laser radiation. According to the exemplary embodiment, the target area 40 is arranged in a target chamber 4 in which vacuum conditions prevail. The target material can be tin, for example, which is provided in drop form. The tin droplet can be heated by a pre-pulse, for example pulsed laser radiation 11 with a wavelength of 1 micron, so that the tin droplet is expanded, vaporised, ionised and/or a weak or possibly strong plasma is generated. A main pulse briefly following the pre-pulse, for example pulsed laser radiation 11 with a wavelength of 10.6 micron, can transfer the essential part of the material influenced by the pre-pulse into the plasma state, whereby the EUV radiation 42 is generated. This EUV radiation 42 is then fed to an exposure device 5 of the lithography system 10, in which the EUV radiation 42 can be used to expose semiconductor substrates.

According to the embodiment, the drive laser 100 comprises a radiation source 1 by means of which, in particular pulsed, laser radiation 11 can be generated. Even if only one radiation source 1 is shown here, two radiation sources 1 can be provided, for example to generate pre-pulses and main pulses of the laser radiation 11, which each follow one another in short succession and are focussed on a target area 40. The laser radiation generated by the radiation source 1 is amplified by an optical amplifier 2. The optical amplifier 2 includes a cavity filled with a laser active gas, e.g., comprising CO₂ and N₂ and He. The laser gas may be excited by radio-frequency (RF) signals applied to the laser gas using electrodes.

Beam guiding devices for guiding the laser radiation 11 are located at specific positions within the drive laser 100 and at the interfaces of the drive laser 100, the focussing device and/or the target chamber 4. Typically, those interfaces include windows and/or apertures which generated stray light that is absorbed within the beam guiding devices.

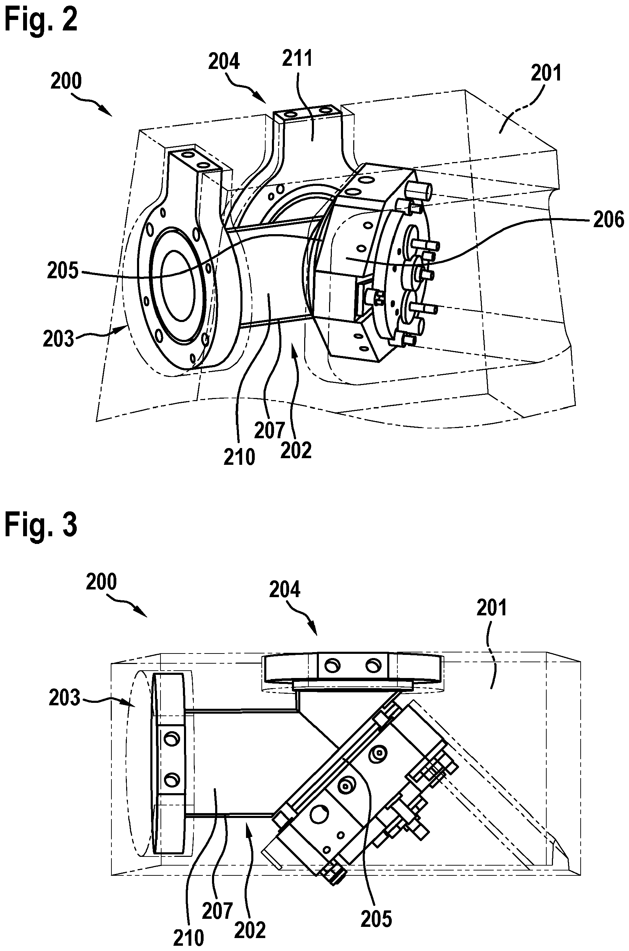

**Fig. 2 and 3** show an exemplary beam guiding device 200 that can be employed in the lithography system 101 according to Fig. 1. For example, the shown beam guiding device 200 may be arranged at an exit opening of the optical amplifier 2, that means at the interface between the drive laser 100 and the focussing device 3. The beam guiding device 200 comprises a body 201, e.g., made from aluminium. For guiding the beams of laser radiation 11, the body includes an inner beam channel 202 with an entry opening 203 and an exit opening 204. Within the beam channel 202, an optical beam guiding element 205, here a mirror, is arranged. The optical beam guiding element 205 is attached indirectly the body 201 via a guiding element holder 206. Here, the optical beam guiding element 205 is attached to an inner surface of the beam channel 202 via the guiding element holder 206.

In order to suppress the stray light induced laser beam drift, sleeves 210, 211 are arranged inside the beam channel 201 such that a gap 207 exists between an outer surface of the sleeve and an inner surface of the body 201 for thermally decoupling the sleeves 210, 211 from the body 201. The gap 207 is typically filled with a gas, in particular with air. The gap 207 may have a value between 1 mm and 5 mm, in particular between 2 mm and 4 mm. IN the disclosed embodiment, the gap is 3 mm.

The sleeves 210, 211 are preferably made from a metal, e.g., aluminum or stainless steel. The sleeves 210, 211 each comprise a tubular sleeve segment which is arranged within a tubular channel segment of the body 201. Here, the tubular sleeve segment is essentially hollow cylindrical and is arranged concentrically with the tubular channel segment. Thus, the gap in particular exists between the outer surface of the tubular sleeve segment and the inner surface of the tubular channel segment. The sleeves 210, 211, however, additionally comprise a flange region which is attached to the body 201 via a thermally insulating connection. A first sleeve 210, is connected via its flange region to the entry opening 203 of the beam channel 202 and a second sleeve 211 is connected via its flange region to the exit opening 204 of the beam channel 202.

The sleeves 210, 211 each comprise a first opening at the flange region and a second opening that is directed towards the other one of the two sleeves 210, 211. At this opening the sleeves are connected to each other and to the optical beam guiding element 205 or the guiding element holder 206. Because of tolerance issues, a perfect contact between both sleeve in their contact region is hardly possible to achieve. In order to reduce stray light transmission through gaps at this contact region between the two sleeves, a labyrinth may be arranged at each sleeve's end.

As mentioned before, the sleeves 210, 211 are connected to the body 201 at their flange regions. Those connections include bolts or screws. A thermally isolating washer is situated between the respective bolts screw and the body 201, wherein the washer preferably consists of a material having a Young's modulus below 4 GPa. The material of the washer may, e.g., be PTFE or PEEK. Thereby, heat transfer via the washer may be drastically reduced. In the gap between the flange region and the body 201 a gas tight sealing rings may be provided, in particular O-rings. Those gas tight sealing rings may be arranged between each of the washers and the respective sleeve 210, 211 and/or between the each of the washers and the body 201.

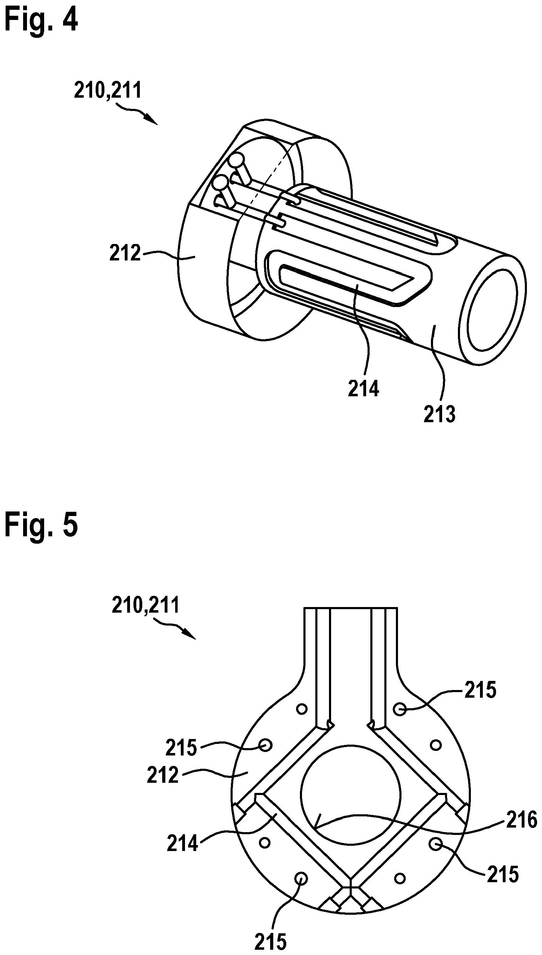

In **Fig. 4****,** a sleeve 210, 211 of a beam guiding device 200 according to another embodiment of the invention is shown in a perspective view. As described before with respect to the first embodiment shown in Fig. 2 and 3, the sleeve 210, 211 comprises a flange region 212 and a tubular region 213. In contrast to the first embodiment, the sleeve according to this embodiment comprises a cooling fluid channel 214 for cooling the sleeve 210, 211. Here, the cooling fluid channel 214 is arranged in both the flange region 212 and the tubular sleeve segment 213. The cooling fluid channel 214 serves to cool the sleeve and thereby reduce heat transmission from the sleeve 210, 211 to the body 201 of the beam guiding device 200.

**Fig. 5** depicts a sleeve 210, 211 of a beam guiding device 200 according to yet another embodiment of the invention in a sectional view of the flange region 212 of the sleeve 210, 211. Similar to the embodiment of Fig. 4, the sleeve 210, 211 according to this embodiment includes a cooling fluid channel 214 for cooling the sleeve 210, 211. Connection holes 215 are shown into which bolts or screws may be inserted in order to fix the sleeve 210, 211 at the body 201 of the beam guiding device 200. Here, the cooling fluid channel 214 is arranged in the flange region 212 such that the cooling fluid channel is between the inner surface 216 of the sleeve 210, 211 and the connection holes 215. Thereby, heat transfer from the inner surface 216, where stray light is absorbed, towards the connection holes 215 can be reduced.

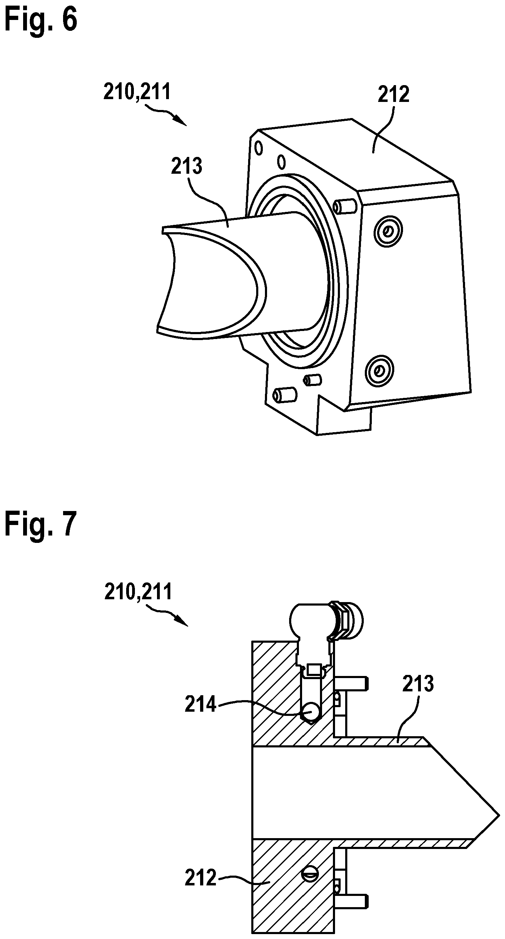

In **Fig. 6** a sleeve 210, 211 of a beam guiding device 200 according to yet another embodiment of the invention is shown in a perspective view.

In **Fig. 7** a sleeve 210, 211 of a beam guiding device 200 according to yet another embodiment of the invention is shown in a sectional view.

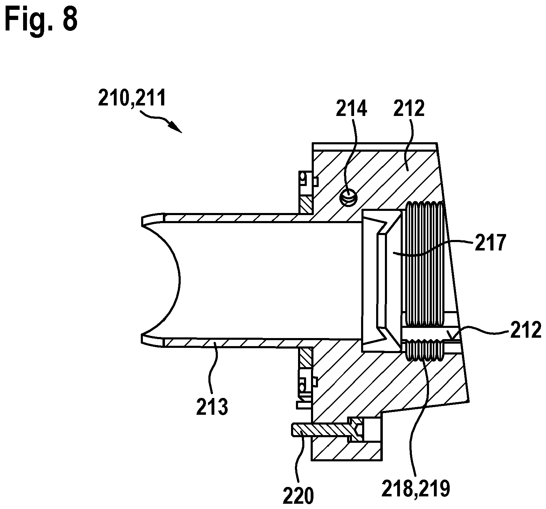

**Fig. 8** depicts a sleeve 210, 211 of a beam guiding device 200 according to yet another embodiment of the invention in a sectional view. In contrast to the embodiments described before, the sleeve 210, 211 according to this embodiment includes a pinhole aperture 217. At the pinhole aperture 217 laser light that is slightly offset the main optical axis is diffracted towards a dedicated absorption region 10 of the sleeve 210, 211. At absorption region 218, the sleeve 210, 211 comprises an absorption structure 219 at the inner surface of the sleeve 210, 211. Here, the absorption structure 219 includes sequence of valleys and peaks on the inner surface 216 of the sleeve 210, 211.

Fig. 8 further depicts a screw 220 introduced in one of the connection openings of the sleeve 210, 211. The screw 220 may be a captive screw, in particular according to DIN 6929.

### Reference Signs:

- 1: laser radiation source
- 2: optical amplifier
- 3: focussing device
- 4: target chamber
- 5: exposure device
- 11: laser radiation
- 40: target area
- 42: EUV radiation

- 101: EUV system

- 200: beam guiding device
- 201: body
- 202: beam channel
- 203: entry opening
- 204: exit opening
- 205: optical beam guiding element, mirror
- 206: guiding element holder
- 207: gap
- 210: sleeve
- 211: sleeve
- 212: flange region
- 213: tubular region
- 214: cooling fluid channel
- 215: connection hole
- 216: inner surface of sleeve
- 217: pinhole aperture
- 218: absorption region
- 219: absorption structure
- 220: screw

## Claims

1. Beam guiding device (200) for guiding laser radiation, comprising
a body (201) with an inner beam channel (202) and
an optical beam guiding element (205), in particular a mirror, that is arranged inside the beam channel (202),
**characterized in that**
at least one sleeve (210, 211) is arranged inside the beam channel (202) such that a gap (207) exists between an outer surface of the sleeve (210, 211) and an inner surface of the body (201) for thermally decoupling the sleeve (210, 211) from the body (201).

2. Beam guiding device (200) according to claim 1, **characterized in that** the gap (207) is filled with a gas, in particular with air.

3. Beam guiding device (200) according to any of the preceding claims, **characterized in that** the gap (207) has a value between 1 mm and 5 mm, in particular between 2 mm and 4 mm, for example essentially 3 mm.

4. Beam guiding device (200) according to any of the preceding claims, **characterized in that** the beam channel (202) has a tubular channel segment and the sleeve (210, 211) has a tubular sleeve segment (213) which is arranged within the tubular channel segment, in particular concentrically within the tubular channel segment, such that the gap (207) exists between the outer surface of the tubular sleeve segment (213) and the inner surface of the tubular channel segment.

5. Beam guiding device (200) according to any of the preceding claims, **characterized in that** the sleeve (210, 211) comprises a flange region (212) which is attached to the body (201) via a thermally insulating connection.

6. Beam guiding device (200) according to claim 5, **characterized in that** the thermally insulating connection comprises a thermally insulating washer, the washer preferably consisting of a material having a Young's modulus below 4 GPa.

7. Beam guiding device (200) according to any of the preceding claims, **characterized in that** the sleeve (210, 211) comprises a cooling fluid channel (214) for cooling the sleeve (210, 211).

8. Beam guiding device (200) according to claim 7, **characterized in that** the cooling fluid channel (214) is arranged in the flange region (212).

9. Beam guiding device (200) according to claim 7 or 8, **characterized in that** the cooling fluid channel (214) is arranged in the tubular sleeve segment (213).

10. Beam guiding device (200) according to any of the preceding claims, **characterized in that** the sleeve (210, 211) comprises a pinhole aperture (217).

11. Beam guiding device (200) according to any of the preceding claims, **characterized in that** at least two sleeves (210, 211) are arranged inside the beam channel (202) such that a gap (207) exists between an outer surface of the sleeves (210, 211) and an inner surface of the body (210) for thermally decoupling the sleeves (210, 211) from the body (201).

12. Beam guiding device (200) according to claim 11, **characterized in that** a first sleeve (210) of the at least two sleeves (210, 211) extends into the beam channel (202) from an entry opening (203) of the body (201) and a second sleeve (211) of the at least two sleeves (210, 211) extends into the beam channel (202) from an exit opening (204) of the body (201).

13. Beam guiding device (200) according to any of claims 11 or 12, **characterized in that** the at least two sleeves (210, 211) each comprise an opening (203) that connects to at least one other sleeve (210, 211) and the optical beam guiding element (205).

14. Lithography system (101), in particular extreme ultraviolet lithography system, comprising a drive laser (100) with a beam guiding device (200) according to any of the preceding claims.

15. Lithography system (101) according to claim 14, **characterized in that** the beam guiding device (200) is arranged nearby a window, in particular a diamond window, or nearby an aperture, that is configured for being arranged in the beam of laser radiation (11).
